(19) Europäisches Patentamt
European Patent Office
Office européen des brevets

(11) **EP 2 880 454 B1**

(12) **EUROPÄISCHE PATENTSCHRIFT**

(45) Veröffentlichungstag und Bekanntmachung des Hinweises auf die Patenterteilung:
**30.06.2021  Patentblatt 2021/26**

(21) Anmeldenummer: **13742186.3**

(22) Anmeldetag: **18.07.2013**

(51) Int Cl.:
*G01R 31/52* (2020.01)       *G01R 31/40* (2020.01)
*H02H 3/33* (2006.01)        *H02S 50/00* (2014.01)
*H02S 50/10* (2014.01)       *H01L 31/02* (2006.01)
*H02H 7/20* (2006.01)

(86) Internationale Anmeldenummer:
**PCT/EP2013/065182**

(87) Internationale Veröffentlichungsnummer:
**WO 2014/019864 (06.02.2014 Gazette 2014/06)**

(54) **VERTEILTE ABLEIT- UND FEHLERSTROMERFASSUNG SOWIE STRINGFEHLERERKENNUNG**

DISTRIBUTED LEAKAGE AND FAULT CURRENT DETECTION AND DETECTION OF STRING DEFECTS

DÉTECTION DE COURANT DE FUITE ET DE DEFAUT ET DÉTEFTION D'UN DÉFAUT D'UN STRING

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **03.08.2012  DE 102012107126**

(43) Veröffentlichungstag der Anmeldung:
**10.06.2015  Patentblatt 2015/24**

(73) Patentinhaber: **SMA Solar Technology AG 34266 Niestetal (DE)**

(72) Erfinder:
• **FALK, Andreas**
  **34131 Kassel (DE)**
• **WILLENBERG, Mario**
  **33102 Paderborn (DE)**

(56) Entgegenhaltungen:
**EP-A1- 2 372 857        US-A1- 2012 048 326
US-A1- 2012 049 627**

• **Anonymous: "Sicherheitsrelevante Aspekte bei PV-Anlagen", , 1. Dezember 2010 (2010-12-01), Seiten 50-55, XP055086223, Gefunden im Internet:**
  **URL:http://www.bender-regenerative.com/fil eadmin/bender-de/downloads/article/DE_22_1 0_GT11.pdf [gefunden am 2013-10-31]**
• **Anonymous: "Sunny Boy SB 5000TL Multi-String Transformatorloser Solarwechselrichter für drei unabhängige PV-Strings", , 1. Januar 2006 (2006-01-01), Seiten 1-60, XP055086227, Gefunden im Internet:**
  **URL:http://files.sma.de/dl/5679/SB5000TL-1 3-SD3306.pdf [gefunden am 2013-10-31]**
• **Photovoltaic Forum: "Fehlermeldung "Ableitstrom zu gross"", , 27. August 2011 (2011-08-27), XP002715737, Online Gefunden im Internet:**
  **URL:http://www.photovoltaikforum.com/stoer ungen-auffaelligkeiten-im-betrieb-von-pv-a nla-f99/fehlermeldung-ableitstrom-zu-gros- -t67510.html [gefunden am 2013-10-29]**
• **None**

EP 2 880 454 B1

**Beschreibung**

## TECHNISCHES GEBIET DER ERFINDUNG

Die Erfindung bezieht sich auf ein Verfahren zur Überwachung eines Wechselrichters mit getrennten eingangsseitigen Anschlüssen für mehrere Gleichstromgeneratoren auf das Auftreten eines kritischen Fehlerstroms, das die Merkmale des Oberbegriffs des unabhängigen Patentanspruchs 1 aufweist. Weiterhin bezieht sich die Erfindung auf einen Wechselrichter zur Durchführung eines solchen Verfahrens mit den Merkmalen des Oberbegriffs des unabhängigen Patentanspruchs 11.

Insbesondere betrifft die vorliegende Erfindung die Überwachung eines Photovoltaikwechselrichters auf das Auftreten eines kritischen Fehlerstroms, der einen Hinweis auf einen Erdschlussfehler darstellt. Bei einem über Anschlussleitungen eines Photovoltaikgenerators gemessenen Differenzstrom tritt neben dem interessierenden resistiven Fehlerstromanteil häufig ein sehr hoher kapazitiver Ableitstromanteil auf, der das Überwachen des resistiven Fehlerstromanteils beispielsweise auf das Auftreten von im Vergleich zu dem Ableitstromanteil kleinen Sprüngen schwierig macht. Der hohe Ableitstromanteil ist dabei auf die große Kapazität von Photovoltaikgeneratoren gegenüber Erde zurückzuführen. Diese Kapazität wirkt sich unmittelbar in einem hohen Ableitstrom aus, sobald die Eingangsleitungen eines Wechselrichters in dessen Betrieb Potentialverschiebungen gegenüber Erde ausgesetzt sind.

Bei transformatorlosen Wechselrichtern und anderen Wechselrichtern ohne galvanische Trennung zwischen Gleichstromeingang und Wechselstromausgang können auch bei nur einem Erdschlussfehler auf der Gleichstromeingangsseite gefährliche resistive Fehlerströme auftreten. Das heißt, auch ein einfacher Erdschlussfehler führt nicht nur dazu, dass eine Eingangsleitung (ungewollt) geerdet wird. Daher gilt die Vorgabe für transformatorlose Wechselrichter, dass diese zuverlässig auf das Auftreten von Fehlerströmen überwacht werden müssen. Dabei sind in aller Regel zwei Kriterien einzuhalten. Zum einen darf der resistive Fehlerstromanteil keine Sprünge, d. h. keine schnellen Anstiege über einen vergleichsweise niedrigen Grenzwert von zum Beispiel 30 mA aufweisen, um einen maximalen Personenschutz sicherzustellen. Zum anderen darf aus Brandschutz- und Anlagenschutzgründen ein insgesamt auftretender Differenzstrom oder auch dessen kapazitiver Ableitstromanteil oder dessen absoluter resistiver Fehlerstromanteil einen deutlich höher liegenden Grenzwert von einigen 100 mA nicht überschreiten. Dieser höhere Grenzwert wächst zudem mit der Gesamtleistung der jeweiligen Photovoltaikanlage an, was für den niedrigeren Grenzwert des kurzzeitigen Anstiegs des resistiven Fehlerstromanteils nicht gilt.

Bei besonders großen Photovoltaikanlagen besteht daher eine besondere Schwierigkeit, aus einem gemessenen Differenzstrom den resistiven Fehlerstromanteil mit ausreichender Genauigkeit zu extrahieren, um ihn auf das Einhalten des niedrigen Grenzwerts für kurzfristige Anstiege zu überwachen.

## STAND DER TECHNIK

Aus der US 2011/0210610 A1 ist eine Photovoltaikanlage bekannt, die eine Vielzahl von parallel geschalteten Photovoltaikgeneratoren aufweist. Dabei erfolgt die Parallelschaltung stufenweise, indem zunächst einzelne Photovoltaikgeneratoren in Verbindungseinheiten zusammengeführt werden und die Ströme von mehreren dieser Verbindungseinheiten dann in einer Sammeleinheit zusammengeführt werden, bevor sie einem Wechselrichter zugeführt werden. In den Verbindungseinheiten wird für jeden einzelnen Photovoltaikgenerator eine Fehlerüberwachung durchgeführt, jedoch nicht speziell auf Erdschlussfehler oder unter Durchführung einer Differenzstrommessung.

Aus der US 2012/0048326 A1 ist eine Photovoltaikanlage bekannt, bei der eine Mehrzahl von Photovoltaikgeneratoren wie in dem zuletzt diskutierten Stand der Technik stufenweise parallel geschaltet ist. Hierbei erfolgt für jeden einzelnen Photovoltaikgenerator in einer Verbindungseinrichtung eine Differenzstrommessung, um den Photovoltaikgenerator auf das Auftreten eines Erdschlussfehlers zu überwachen. Eine weitere Differenzstrommessung erfolgt in einem gemeinsamen Wechselrichter für den Gleichstrom von allen Photovoltaikgeneratoren, um auch die Leitungen zwischen den Differenzstromsensoren der einzelnen Photovoltaikgeneratoren und dem Wechselrichter auf das Auftreten eines Erdschlussfehlers zu überwachen. Eine solche Überwachung auf das Auftreten eines Erdschlussfehlers bei einer Photovoltaikanlage ist auch aus der US 2012/0049627 A1 bekannt.

Aus der US 2002/0105765 A1 ist eine Photovoltaikanlage bekannt, bei der der Fehlerstromanteil eines Differenzstroms über Eingangsleitungen eines Photovoltaikwechselrichters unter Berücksichtigung der aktuellen Kapazität des angeschlossenen Photovoltaikgenerators und unter Berücksichtigung von Potentialschwankungen der Eingangsleitungen gegenüber Erde ermittelt wird, um diesen auch bei großen veränderlichen kapazitiven Ableitstromanteilen an dem Differenzstrom zuverlässig auf das Auftreten kleiner Sprünge überwachen zu können.

Aus der WO 2011/026874 A2 ist ein Verfahren zum Überwachen einer Mehrzahl von Photovoltaikgeneratoren einer Photovoltaikanlage, die hier als Strings bezeichnet werden, bekannt, um beispielsweise einen Teilausfall auch nur eines Substrings eines Photovoltaikgenerators frühzeitig erkennen zu können. Dazu werden Ströme von den einzelnen Strings gemessen und zeitgleich auftretende Ströme miteinander in Beziehung gesetzt sowie der Langzeitverlauf dieser Beziehungen ausgewertet.

## AUFGABE DER ERFINDUNG

Der Erfindung liegt die Aufgabe zugrunde, ein Verfahren zur Überwachung eines Wechselrichters auf das Auftreten eines kritischen Fehlerstroms und einen zur Durchführung eines solchen Verfahrens geeigneten Wechselrichter aufzuzeigen, mit denen auch bei großer elektrischer Leistung und entsprechend großer Kapazität angeschlossener Photovoltaikgeneratoren kleine kurzfristige Anstiege des Fehlerstroms ebenso zuverlässig erkannt werden können wie Absolutwerte des gesamten über den Wechselrichter fließenden Differenzstroms oder eines bestimmten Stromanteils dieses Differenzstroms.

## LÖSUNG

Die Aufgabe der Erfindung wird durch ein Verfahren zur Überwachung eines Wechselrichters mit getrennten eingangsseitigen Anschlüssen für mehrere Gleichstromgeneratoren auf das Auftreten eines kritischen Fehlerstroms, das die Merkmale des unabhängigen Patentanspruchs 1 aufweist, sowie durch einen Wechselrichter zur Durchführung eines solchen Verfahrens mit den Merkmalen des unabhängigen Patentanspruchs 11 gelöst. Bevorzugte Ausführungsformen des erfindungsgemäßen Verfahrens und des erfindungsgemäßen Wechselrichters sind in den abhängigen Patentansprüchen definiert.

## BESCHREIBUNG DER ERFINDUNG

Bei dem erfindungsgemäßen Verfahren zur Überwachung eines Wechselrichters mit getrennten eingangsseitigen Anschlüssen für mehrere Gleichstromgeneratoren, insbesondere Photovoltaikgeneratoren, auf das Auftreten eines kritischen Fehlerstroms werden in dem Wechselrichter Differenzströme über mindestens zwei Paare von Eingangsleitungen getrennt gemessen, die die an unterschiedlichen eingangsseitigen Anschlüssen eingespeisten Ströme führen, wobei alle Paare von Eingangsleitungen zusammen, d.h. in ihrer Gesamtheit alle an den Anschlüssen eingespeisten Ströme führen. Die Differenzströme werden für jedes Paar von Eingangsleitungen separat mit einem Grenzwert verglichen, wobei bei Überschreiten des Grenzwerts auf einen Fehler erkannt wird. Zusätzlich wird eine Summe von zeitgleich auftretenden Differenzströmen über alle Paare von Eingangsleitungen bestimmt und mit einem weiteren Grenzwert verglichen, wobei auch bei Überschreiten des weiteren Grenzwerts auf einen Fehler erkannt wird.

Für die Durchführung des erfindungsgemäßen Verfahrens werden Differenzströme ausschließlich in dem Wechselrichter selbst gemessen. Obwohl dort die Möglichkeit bestünde, den gesamten Differenzstrom, der über den Wechselrichter fließt, mit einem einzigen Differenzstromsensor zu erfassen, werden erfindungsgemäß hierzu mindestens zwei Differenzstromsensoren verwendet, die jeweils nur die von einer Teilmenge der Gleichstromgeneratoren kommenden Ströme auf das Auftreten von Differenzströmen überwachen. Hierdurch werden die kapazitiven Ableitstromanteile der gemessenen Differenzströme gegenüber einer einzigen Differenzstrommessung, die über die Gesamtheit der Gleichstromgeneratoren erfolgt, reduziert. Wenn beispielsweise jeder von zwei Differenzstromsensoren die Ströme von der Hälfte aller Gleichstromgeneratoren erfasst, werden die Absolutwerte der kapazitiven Ableitstromanteile der Differenzströme halbiert. Entsprechend kann mit einer noch größeren Anzahl von Differenzstromsensoren der jeweilige kapazitive Ableitstromanteil weiter reduziert werden. In Folge wird die Empfindlichkeit bei der Überwachung des jeweiligen Differenzstroms auf das Auftreten eines kleinen kurzfristigen Anstiegs seines Fehlerstromanteils erhöht. Dies kann so weit gehen, dass die Differenzströme, die mit jedem einzelnen Differenzstromsensor gemessen werden, direkt auf das Auftreten sprunghafter Anstiege überwacht werden können, d. h. ohne vorher einen kapazitiven Ableitstromanteil abzutrennen oder ohne anderweitig den reinen resistiven Fehlerstromanteil zu extrahieren. Die Empfindlichkeitssteigerung in Bezug auf kleine Anstiege des resistiven Fehlerstromanteils des über den Wechselrichter insgesamt fließenden Stroms wird durch die ungewöhnliche Mehrzahl von Differenzstromsensoren in dem Wechselrichter erreicht. Zugleich wird bei der vorliegenden Erfindung jedoch auch der interessierende Absolutwert des Differenzstroms oder eines seiner Stromanteile durch die entsprechende Summe über die Signale der einzelnen Differenzstromsensoren erfasst und kann entsprechend mit dem zugehörigen Grenzwert verglichen werden, der nur für die jeweilige Photovoltaikanlage als Ganzes gilt. Hier ergeben sich markante Vorteile dadurch, dass dieser Grenzwert nicht auf die einzelnen Differenzstromsensoren aufgeteilt wird, sondern nur die jeweilige Summe mit dem Grenzwert verglichen wird, weil dieser Grenzwert auch nur von der gesamten Photovoltaikanlage eingehalten werden muss und das singuläre Überschreiten eines Anteils des Grenzwerts an einem einzelnen der Differenzstromsensoren nur ein unnötiges Abschalten der ganzen Photovoltaikanlage zur Folge hätte.

Wie bereits angesprochen wurde, ist der Grenzwert, mit dem die Differenzströme für jedes Paar von Eingangsleitungen separat verglichen werden, üblicherweise ein Grenzwert für einen Stromanstieg binnen bestimmter Zeit. Konkret gilt dieser Grenzwert üblicherweise für einen resistiven Fehlerstromanteil der Differenzströme. Wie bereits angesprochen wurde, kann daher zu jedem der gemessenen Differenzströme dessen resistiver Fehlerstromanteil bestimmt werden, und jeder der gemessenen Differenzströme kann in Form seines resistiven Fehlerstromanteils mit dem Grenzwert für den resistiven Fehlerstromanteil der Differenzströme verglichen werden. Auch wenn sie vorteilhaft ist, ist die getrennte Bestimmung der resistiven Fehlerstromanteile jedoch nicht unbedingt zwingend. Vielmehr können, solange die weiteren Anteile, insbesondere ein kapazitiver Ableitstromanteil der Differenzströme, klein bleiben, auch direkt die gemessenen Differenzströme mit dem Grenzwert verglichen werden.

Der weitere Grenzwert, mit dem die Summe von zeitgleich auftretenden Differenzströmen über alle Paare von Eingangsleitungen verglichen wird, kann ein Grenzwert für die direkte Summe der Differenzströme oder, was bevorzugt ist, ein Grenzwert für eine Summe der kapazitiven Ableitstromanteile der Differenzströme sein. Die Summe der kapazitiven Ableitstromanteile der Differenzströme kann dabei auch als kapazitiver Ableitstromanteil der Summe der Differenzströme ermittelt werden. Zu jedem der gemessenen Differenzströme kann also dessen kapazitiver Ableitstromanteil bestimmt werden; und die Summe der zeitgleich auftretenden Differenzströme über alle Paare der Eingangsleitungen kann in Form der Summe ihrer kapazitiven Ableitstromanteile bestimmt und mit dem weiteren Grenzwert verglichen werden. Alternativ kann die Summe der zeitgleich auftretenden Differenzströme über alle Paare der Eingangsleitungen in Form eines kapazitiven Ableitstromanteils der Summe der zeitgleich auftretenden Differenzströme bestimmt und mit dem weiteren Grenzwert verglichen werden.

Grundsätzlich kann es sich bei dem weiteren Grenzwert auch um einen Grenzwert für eine Summe der resistiven Fehlerstromanteile der Differenzströme oder einen resistiven Fehlerstromanteil der Summe der Differenzströme handeln.

Verfahren zur Bestimmung des resistiven Fehlerstromanteils und umgekehrt auch des kapazitiven Ableitstromanteils an einem Differenzstrom, wie sie auch hier anwendbar sind, gehen zum Beispiel aus der EP 2 372 857 A1 und der DE 10 2011 002 084 A1 hervor.

Jedes Paar von Eingangsleitungen, das mit einem der Differenzstromsensoren überwacht wird, kann die an den Anschlüssen für mindestens zwei Gleichstromgeneratoren eingespeisten Ströme führen. Das heißt, bei der vorliegenden Erfindung muss nicht für jeden einzelnen Gleichstromgenerator ein eigener Differenzstromsensor vorgesehen sein. Vielmehr können Gleichstromgeneratoren zur Überwachung durch einen einzigen Differenzstromsensor solange zusammengefasst werden, wie sichergestellt ist, dass auch ein kleiner aber relevanter Anstieg des Fehlerstromanteils des Differenzstroms sicher erkannt wird.

Beim Erkennen eines Fehlers aufgrund der von jedem der Differenzstromsensoren erfassten Differenzströme oder deren Summe wird der Wechselrichter sofort abgeschaltet und/oder von einem ausgangsseitig angeschlossenen Wechselstromnetz getrennt, letzteres insbesondere dann, wenn der Wechselrichter keine galvanische Trennung von dem Wechselstromnetz aufweist.

Wenn ein Fehler nur an einem Paar von Eingangsleitungen des Wechselrichters erkannt wird, können diese Eingangsleitungen auch selektiv aufgetrennt werden oder die zugehörigen Anschlüsse bzw. die daran angeschlossenen Gleichstromgeneratoren abgeschaltet werden.

Die erfindungsgemäße Messung von Differenzströmen über Teilmengen der an den Wechselrichter angeschlossenen Gleichstromgeneratoren ermöglicht es auch, diese Teilmengen getrennt voneinander auf das Auftreten von Fehlern im Sinne eines Ausfalls einzelner Gleichstromgeneratoren oder einzelner Substrings von Photovoltaikgeneratoren als Gleichstromgeneratoren zu überwachen. Dabei kann ein Einbruch des Differenzstroms über einem Paar von Eingangsleitungen unmittelbar als Hinweis auf einen Ausfall eines daran angeschlossenen Gleichstromgenerators gewertet werden. Durch den Ausfall eines Photovoltaikgenerators, beispielsweise infolge des Durchbrennens beider ihn absichernden Schmelzsicherungen, entfällt der kapazitive Ableitstromanteil des Photovoltaikgenerators an dem Differenzstrom. Aber auch bereits bei Durchbrennen nur einer dieser Sicherungen kommt es zu einem Rückgang des kapazitiven Ableitstromanteils des Differenzstroms.

Dieses Entfallen oder dieser Rückgang des kapazitiven Ableitstromanteils wird besonders leicht erkannt, wenn zeitgleich Differenzströme über alle Paare von Eingangsleitungen, d. h. die mit den einzelnen Differenzstromsensoren gemessenen Differenzströme, verglichen werden. Hierdurch können Änderungen, die bei allen Differenzströmen gleichzeitig auftreten, externen Ereignissen zugeordnet werden und von tatsächlichen Ausfällen einzelner Gleichstromgeneratoren, die sich nur auf die mit einem einzelnen Differenzstromsensor gemessenen Differenzströme auswirken, getrennt werden.

Zudem können Langzeitverläufe von Differenzströmen und insbesondere deren Verhältnisse untereinander ausgewertet werden. Grundsätzlich können dabei dieselben Algorithmen zur Anwendung kommen, wie sie aus der WO 2011/026874 A2 bekannt sind und deren Inhalt hier insoweit einbezogen wird. Gemäß der WO 2011/026874 A2 wird der jeweilige Stringstrom, d. h. ein Gegentaktstrom, beobachtet, während bei der hier vorliegenden Erfindung auf den Differenzstrom, d. h. einen Gleichtaktstrom, abgestellt wird.

Bei einem erfindungsgemäßen Wechselrichter zur Durchführung des erfindungsgemäßen Verfahrens mit getrennten eingangsseitigen Anschlüssen für mehrere Gleichstromgeneratoren, Messeinrichtungen, die die Differenzströme zwischen Eingangsleitungen messen, welche in ihrer Gesamtheit alle an den Anschlüssen eingespeisten Ströme führen, und mit Überwachungseinrichtungen, die die Differenzströme mit einem Grenzwert vergleichen und bei Überschreiten des Grenzwerts auf einen Fehler erkennen, weisen die Messeinrichtungen für jedes von mindestens zwei Paaren der Eingangsleitungen, wobei diese mindestens zwei Paare der Eingangsleitungen die an unterschiedlichen eingangsseitigen Anschlüssen eingespeisten Ströme führen, einen separaten Differenzstromsensor auf. Die Überwachungseinrichtungen vergleichen die mit jedem der Differenzstromsensoren gemessenen Differenzströme separat mit dem Grenzwert. Weiterhin bestimmen die Überwachungseinrichtungen zusätzlich eine Summe von zeitgleich mit allen Differenzstromsensoren gemessenen Differenzströmen und vergleichen diese Summe mit einem weiteren Grenzwert. Auch bei Überschreiten dieses weiteren Grenzwerts erkennt die Überwachungseinrichtung auf einen Fehler.

Alle bevorzugten Ausführungsformen des erfindungsgemäßen Verfahrens haben ihre Entsprechung bei dem erfindungsgemäßen Wechselrichter, da das Verfahren vollständig in dem Wechselrichter durchgeführt wird.

## KURZBESCHREIBUNG DER FIGUREN

Die Erfindung wird im Folgenden anhand von Ausführungsbeispielen unter Bezugnahme auf die beigefügten Zeichnungen näher erläutert und beschrieben.

Fig. 1      zeigt einen erfindungsgemäßen Wechselrichter zwischen einer Mehrzahl von Photovoltaikgeneratoren und einem Wechselstromnetz.

Fig. 2      zeigt eine Abwandlung des Wechselrichters gemäß Fig. 1.

Fig. 3      zeigt ein Detail des Wechselrichters gemäß Fig. 2 beim Auftreten eines Ausfalls eines der Photovoltaikgeneratoren; und

Fig. 4      zeigt die Zusammenhänge zwischen einem gemessenen Fehlerstrom $I_{diff}$ und seinem resistiven Fehlerstromanteil $I_R$ sowie seinem kapazitiven Ableitstromanteil $I_C$.

## FIGURENBESCHREIBUNG

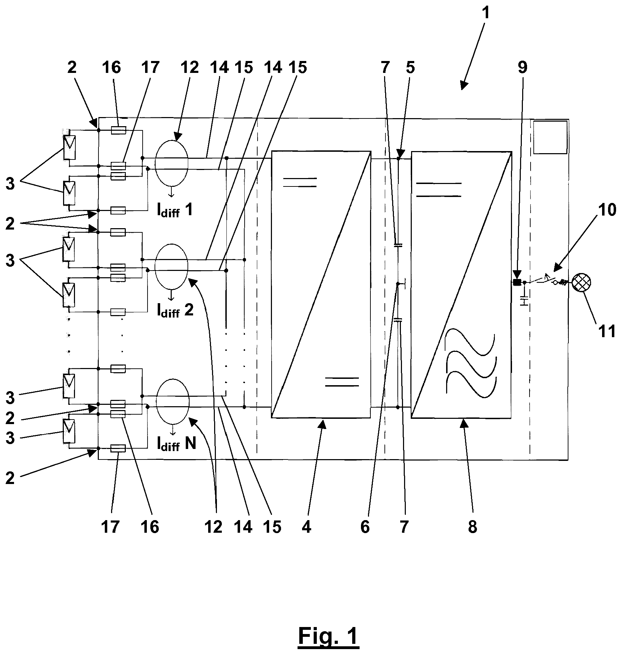

Der in **Fig. 1** dargestellte Wechselrichter 1 weist mehrere Anschlüsse 2 für jeweils einen Photovoltaikgenerator 3 als konkretes Beispiel für einen Gleichstromgenerator auf. In dem Wechselrichter 1 werden die Photovoltaikgeneratoren 3 stufenweise parallel geschaltet, so dass ihre Ausgangsspannungen jeweils gleich sind und einer eingangsseitigen Zwischenkreisspannung eines eingangsseitigen DC/DC-Wandlers 4 des Wechselrichters 1 entsprechen. Dieser DC/DC-Wandler legt eine Zwischenkreisspannung über einem Gleichspannungszwischenkreis 5, der hier beispielhaft mit geerdetem Mittelpunkt 6 und zwei Kondensatoren 7 ausgeführt ist, fest, aus dem ein hier dreiphasiger DC/AC-Wandler 8 des Wechselrichters 1 gespeist wird. Der DC/AC-Wandler 8 ist über ein Netzfilter 9 und einen Netzschalter 10 an ein Wechselstromnetz 11 angeschlossen. Zur Überwachung des Wechselrichters 1 auf das Auftreten kritischer Fehlerströme, die einen Hinweis auf Erdschlussfehler im Bereich der Photovoltaikgeneratoren 3 und ihrer Parallelschaltung geben, sind mehrere Differenzstromsensoren 12 vorgesehen, mit denen jeweils der Differenzstrom über ein Paar von Eingangsleitungen 14, 15 erfasst wird. Diese Eingangsleitungen 14, 15 führen hier den Strom von jeweils zwei Photovoltaikgeneratoren, wobei auch noch mehr Photovoltaikgeneratoren an jedes Paar von Eingangsleitungen 14, 15 angeschlossen sein können, aber auch nur ein einziger Photovoltaikgenerator 3. Der mit jedem der Differenzstromsensoren 12 gemessene Differenzstrom $I_{diff}$ wird getrennt von den anderen Differenzströmen daraufhin überprüft, ob er einen kurzfristigen Anstieg oberhalb eines Grenzwertes aufweist. Diese Überprüfung kann direkt an dem Differenzstrom $I_{diff}$ oder an seinem resistiven Fehlerstromanteil $I_R$ durchgeführt werden.

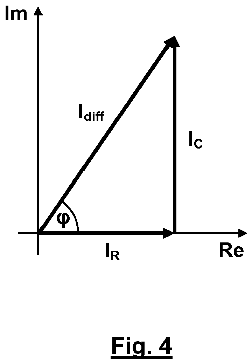

Dieser resistive Fehlerstromanteil ist der Realteil des Differenzstroms $I_{diff}$, d. h. der Strom, der mit der Spannung in Phase ist. Demgegenüber ist ein kapazitiver Ableitstromanteil $I_C$ der Imaginärteil des Differenzstroms $I_{diff}$, der einen Phasenversatz von 90° zur Spannung aufweist. Diese Zusammenhänge gehen aus **Fig. 4** hervor. Fig. 4 lässt dabei erkennen, dass es ein großer kapazitiver Ableitstromanteil $I_C$ erschwert, durch Beobachten des Betrags oder auch des Phasenwinkels $\varphi$ des Differenzstroms $I_{diff}$ einen absolut gesehen viel kleineren aber doch relevanten Anstieg des resistiven Fehlerstromanteils $I_R$ zu erkennen.

Dadurch, dass der Differenzstrom $I_{diff}$ bei der Photovoltaikanlage gemäß Fig. 1 in dem Wechselrichter 1 auf mehrere Differenzstromsensoren 12 aufgeteilt ist, ist der kapazitive Ableitstrom aufgrund der großen Kapazitäten der Photovoltaikgeneratoren gegenüber Erde für jeden Differenzstromsensor auf ungefähr $\dfrac{1}{N}$ reduziert, wobei N die Anzahl der Differenzstromsensoren ist. Entsprechend ist die Empfindlichkeit bei der Überwachung des gesamten Differenzstroms in Bezug auf das Erkennen eines relevanten Anstiegs des Fehlerstromanteils $I_R$ um einen Faktor N verbessert.

Zugleich wird bei der Photovoltaikanlage gemäß Fig. 1 die Summe der Differenzströme $\Sigma\ I_{diff}$ i bestimmt, wobei $I_{diff}$ i mit i von 1 bis N die Differenzströme von den einzelnen Differenzstromsensoren 12 sind, und mit einem weiteren Grenzwert verglichen. Dies kann durch direkten Vergleich der Summe $\Sigma\ I_{diff}$ i mit dem weiteren Grenzwert erfolgen. Es kann aber auch ein Stromanteil der Summe der zeitgleich gemessenen Differenzströme $I_{diff}$ mit dem weiteren Grenzwert verglichen werden. Dieser Stromanteil der Summe der zeitgleich gemessenen Differenzströme $I_{diff}$ kann aus der Summe $\Sigma\ I_{diff}$ i selbst bestimmt werden oder als Summe der entsprechenden Stromanteile der einzelnen Differenzströme $I_{diff}$ i. Dabei kann der Stromanteil in einer bevorzugten Ausführungsform anstatt des Fehlerstromanteils $I_R$ auch der kapazitive Ableitstromanteil $I_C$ sein.

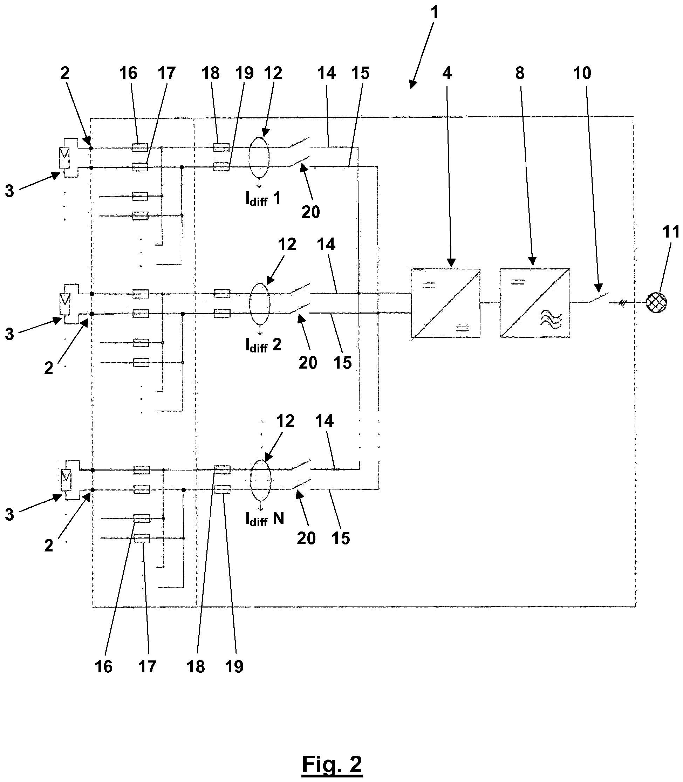

Bei der in **Fig. 2** dargestellten Photovoltaikanlage sind N Differenzstromsensoren 12 in dem Wechselrichter 1 vorgesehen, mit denen jeweils der über ein Paar von Eingangsleitungen 14, 15 fließende Differenzstrom $I_{diff}$ von drei oder mehr Photovoltaikgeneratoren 3 erfasst wird. Während in Fig. 1 die Photovoltaikgeneratoren 3 in dem Wechselrichter 1 jeweils einzeln durch ein Paar von Sicherungen 16, 17 abgesichert sind, sind hier zusätzliche Sicherungen 18, 19 in den Eingangsleitungen 14 und 15 angeordnet. Die Sicherungen 16 und 17 können in diesem Fall auch außerhalb des Wechselrichters 1 angeordnet sein, beispielsweise in einer Verbindungseinheit, über die mehrere Photovoltaikgeneratoren 3 parallel an ein Paar von Eingangsleitungen 14 und 15 angeschlossen werden, bevor sie mit den Anschlüssen 2 des Wechselrichters 1 verbunden werden. Zudem kann jedes Paar von Eingangsleitungen einzeln mit einem Schalter 20 aufgetrennt werden. Mit einem solchen Auftrennen kann auf einen kritischen Anstieg des resistiven Fehlerstromanteils des Differenzstroms $I_{diff}$ i über einem einzelnen Paar von Eingangsleitungen 14 und 15, der entsprechend nur von einem der Differenzstromsensoren 12 registriert wird, reagiert werden. Wenn hingegen die Summe der Differenzströme $\sum I_{diff}$ i den weiteren Grenzwert überschreitet, kann zwar auch versucht werden, deren größten Summanden durch Öffnen eines der Schalter 20 zu beseitigen, dann muss aber auch der weitere Grenzwert für die verbleibende Summe anteilig reduziert werden. Häufig ist es daher erforderlich, den Netzschalter 10 zu öffnen und den Wechselrichter 1, insbesondere seinen DC/AC-Wandler 8, abzuschalten, wenn der weitere Grenzwert für die Summe der Differenzströme $\sum I_{diff}$ i überschritten wird.

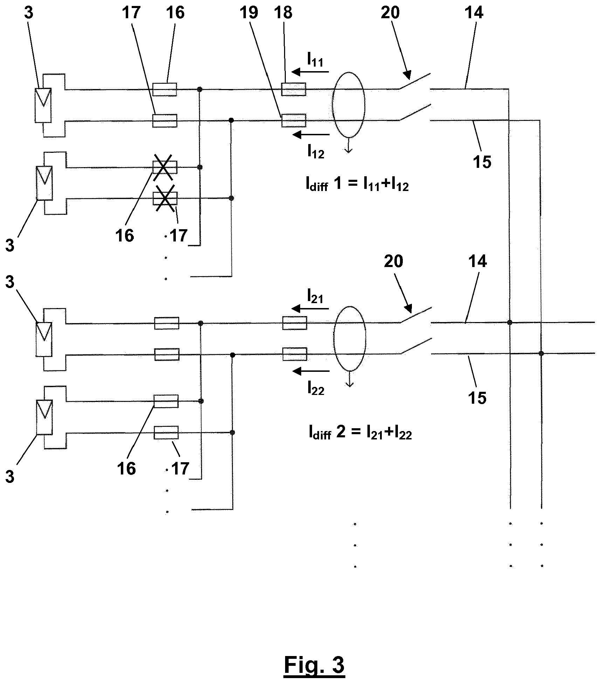

**Fig. 3** illustriert, dass die Differenzströme $I_{diff}$ auch dazu verwendet werden können, Ausfälle von einzelnen Photovoltaikgeneratoren zu erfassen. Beispielsweise haben hier beide Sicherungen 16 und 17 des zweiten Photovoltaikgenerators 3 ausgelöst, so dass der Photovoltaikgenerator 3 nicht mehr mit den Eingangsleitungen 14 und 15 verbunden ist. Hierdurch entfällt die Ableitkapazität des zweiten Photovoltaikgenerators 3 und damit ein wesentlicher Teil des kapazitiven Ableitstromanteils des Fehlerstroms $I_{diff}$ 1. Aber auch das Auslösen nur einer der Sicherungen 16 und 17 reduziert den kapazitiven Ableitstromanteil des Fehlerstroms $I_{diff}$ 1. Auch wenn diese Reduktion kleiner als bei einem Auslösen beider Sicherungen 16 und 17 ausfällt, tritt sie bei einem Vergleich des Differenzstroms $I_{diff}$ 1 mit dem Differenzstrom $I_{diff}$ 2, der zeitgleich für nicht ausgefallene Photovoltaikgeneratoren 3 gemessen wird, signifikant hervor.

## BEZUGSZEICHENLISTE

1 Wechselrichter
2 Anschluss
3 Photovoltaikgenerator
4 DC/DC-Wandler
5 Gleichspannungszwischenkreis
6 geerdeter Mittelpunkt
7 Kondensator
8 DC/AC-Wandler
9 Netzfilter
10 Netzschalter
11 Wechselstromnetz
12 Differenzstromsensor
13 (frei)
14 Eingangsleitung
15 Eingangsleitung
16 Sicherung
17 Sicherung
18 Sicherung
19 Sicherung
20 Schalter

## Patentansprüche

1. Verfahren zur Überwachung eines Wechselrichters (1) mit getrennten eingangsseitigen Anschlüssen (2) für mehrere Gleichstromgeneratoren auf das Auftreten eines kritischen Fehlerstroms ($I_R$),

   - wobei in dem Wechselrichter (1) Differenzströme ($I_{diff}$) zwischen Eingangsleitungen (14, 15) gemessen werden, wobei diese Eingangsleitungen (14, 15) in ihrer Gesamtheit alle an den einzelnen Anschlüssen (2) eingespeisten Ströme führen, und
   - wobei die Differenzströme ($I_{diff}$) mit einem Grenzwert verglichen werden, wobei bei Überschreiten des Grenzwerts auf einen Fehler erkannt wird,

   **dadurch gekennzeichnet,**

   - **dass** die Differenzströme ($I_{diff}$) in dem Wechselrichter (1) über mindestens zwei Paare der Eingangsleitungen (14, 15) getrennt gemessen werden, wobei diese mindestens zwei Paare der Eingangsleitungen (14, 15) die an unterschiedlichen eingangsseitigen Anschlüssen (2) eingespeisten Ströme führen;
   - **dass** die Differenzströme ($I_{diff}$) für jedes Paar von Eingangsleitungen (14, 15) separat mit dem Grenzwert verglichen werden; und
   - **dass** zusätzlich eine Summe der zeitgleich getrennt gemessenen Differenzströme ($I_{diff}$) über alle Paare der Eingangsleitungen (14, 15) bestimmt und mit einem weiteren Grenzwert verglichen wird, wobei bei Überschreiten des weiteren Grenzwerts ebenfalls auf einen Fehler erkannt wird.

2. Verfahren nach Anspruch 1, **dadurch gekennzeichnet, dass** der Grenzwert, mit dem die Differenzströme ($I_{diff}$) für jedes Paar von Eingangsleitungen (14, 15) separat verglichen werden, ein Grenzwert für einen Stromanstieg binnen bestimmter Zeit ist.

3.  Verfahren nach Anspruch 1 oder 2, **dadurch gekennzeichnet, dass** der Grenzwert, mit dem die Differenzströme ($I_{diff}$) für jedes Paar von Eingangsleitungen (14, 15) separat verglichen werden, ein Grenzwert für einen Anstieg eines resistiven Fehlerstromanteil ($I_R$) der Differenzströme ($I_{diff}$) ist, wobei optional zu jedem der gemessenen Differenzströme ($I_{diff}$) dessen resistiver Fehlerstromanteil ($I_R$) bestimmt wird und dass jeder der gemessenen Differenzströme ($I_{diff}$) in Form seines resistiven Fehlerstromanteils ($I_R$) mit dem Grenzwert verglichen wird.

4.  Verfahren nach einem der vorhergehenden Ansprüche, **dadurch gekennzeichnet, dass** der weitere Grenzwert, mit dem die Summe der zeitgleich getrennt gemessenen Differenzströme ($I_{diff}$) über alle Paare von Eingangsleitungen (14, 15) verglichen wird, ein Grenzwert für eine Summe der kapazitiven Ableitstromanteile ($I_C$) der Differenzströme ($I_{diff}$) ist.

5.  Verfahren nach Anspruch 4, **dadurch gekennzeichnet, dass**

    - entweder zu jedem der gemessenen Differenzströme ($I_{diff}$) dessen kapazitiver Ableitstromanteil ($I_C$) bestimmt wird und dass die Summe der zeitgleich getrennt gemessenen Differenzströme ($I_{diff}$) über alle Paare der Eingangsleitungen (14, 15) in Form der Summe ihrer kapazitiven Ableitstromanteile ($I_C$) bestimmt und mit dem weiteren Grenzwert verglichen wird, -
    - oder die Summe der zeitgleich getrennt gemessenen Differenzströme ($I_{diff}$) über alle Paare der Eingangsleitungen (14, 15) in Form eines kapazitiven Ableitstromanteils der Summe der zeitgleich getrennt gemessenen Differenzströme ($I_{diff}$) bestimmt und mit dem weiteren Grenzwert verglichen wird.

6.  Verfahren nach einem der vorhergehenden Ansprüche, **dadurch gekennzeichnet, dass** jedes Paar von Eingangsleitungen (14, 15) die an den Anschlüssen (2) für mindestens zwei Gleichstromgeneratoren eingespeisten Ströme führt.

7.  Verfahren nach einem der vorhergehenden Ansprüche, **dadurch gekennzeichnet, dass** der Wechselrichter (1) beim Erkennen eines Fehlers abgeschaltet und/oder von einem ausgangsseitig angeschlossenen Wechselstromnetz (11) getrennt wird.

8.  Verfahren nach einem der vorhergehenden Ansprüche, **dadurch gekennzeichnet, dass** beim Erkennen eines Fehlers an nur einem Paar von Eingangsleitungen (14, 15), diese Eingangsleitungen (14, 15) selektiv aufgetrennt oder die zugehörigen Anschlüsse (2) selektiv abgeschaltet werden.

9.  Verfahren nach einem der vorhergehenden Ansprüche, **dadurch gekennzeichnet, dass** ein Einbruch des Differenzstroms ($I_{diff}$) über einem Paar von Eingangsleitungen (14, 15) als Hinweis auf einen Ausfall eines daran angeschlossenen Gleichstromgenerators gewertet wird.

10. Verfahren nach einem der vorhergehenden Ansprüche, **dadurch gekennzeichnet, dass** zusätzlich die zeitgleich getrennt gemessenen Differenzströme ($I_{diff}$) über die mindestens zwei Paare von Eingangsleitungen (14, 15) miteinander verglichen werden, wobei optional zusätzlich Langzeitverläufe der Differenzströme ($I_{diff}$) über die mindestens zwei Paare von Eingangsleitungen (14, 15) ausgewertet werden.

11. Wechselrichter (1) zur Durchführung des Verfahrens nach einem der vorhergehenden Ansprüche mit:

    - getrennten eingangsseitigen Anschlüssen (2) für mehrere Gleichstromgeneratoren,
    - Messeinrichtungen, die Differenzströme ($I_{diff}$) zwischen Eingangsleitungen (14, 15) messen, welche in ihrer Gesamtheit alle an den Anschlüssen (2) eingespeisten Ströme führen, und
    - Überwachungseinrichtungen, die die Differenzströme ($I_{diff}$) mit einem Grenzwert vergleichen und bei Überschreiten des Grenzwerts auf einen Fehler erkennen,

    **dadurch gekennzeichnet,**

    - **dass** die Messeinrichtungen für jedes von mindestens zwei Paaren der Eingangsleitungen (14, 15), wobei diese mindestens zwei Paare der Eingangsleitungen (14, 15) die an unterschiedlichen eingangsseitigen Anschlüssen (2) eingespeisten Ströme führen, einen separaten Differenzstromsensor (12) aufweisen;
    - **dass** die Überwachungseinrichtungen die mit jedem der Differenzstromsensoren (12) gemessenen Differenzströme ($I_{diff}$) separat mit dem Grenzwert vergleichen; und
    - **dass** die Überwachungseinrichtungen zusätzlich eine Summe der zeitgleich mit allen separaten Differenzstromsensoren (12) getrennt gemessenen Differenzströme ($I_{diff}$) bestimmen und mit einem weiteren Grenzwert vergleichen und bei Überschreiten des weiteren Grenzwerts ebenfalls auf einen Fehler erkennen.

12. Wechselrichter nach Anspruch 11, **dadurch gekennzeichnet, dass** die Überwachungseinrichtungen zu jedem der mit einem der Differenzstromsensoren (12) gemessenen Differenzströme ($I_{diff}$) dessen resistiven Fehlerstromanteil ($I_R$) bestimmt, wobei die Überwachungseinrichtungen optional jeden der gemessenen Differenzströme ($I_{diff}$) in Form seines resistiven Fehlerstromanteils ($I_R$) mit dem Grenzwert vergleichen.

13. Wechselrichter nach Anspruch 11 oder 12, **dadurch gekennzeichnet, dass** die Überwachungseinrichtungen zu jedem der mit einem der Differenzstromsensoren (12) gemessenen Differenzströme ($I_{diff}$) dessen kapazitiven Ableitstromanteil ($I_C$) bestimmen, wobei die Überwachungseinrichtungen optional die Summe der zeitgleich getrennt gemessenen Differenzströme ($I_{diff}$) über alle Paare der Eingangsleitungen (14, 15) in Form der Summe ihrer kapazitiven Ableitstromanteile ($I_C$) bestimmen und mit dem weiteren Grenzwert vergleichen.

14. Wechselrichter nach Anspruch 11 oder 12, **dadurch gekennzeichnet, dass** die Überwachungseinrichtungen die Summe der zeitgleich auftretenden Differenzströme ($I_{diff}$) über alle Paare der Eingangsleitungen (14, 15) in Form eines kapazitiven Ableitstromanteils der Summe der zeitgleich getrennt gemessenen Differenzströme ($I_{diff}$) bestimmen und mit dem weiteren Grenzwert vergleichen.

15. Wechselrichter nach einem der Ansprüche 11 bis 14, **dadurch gekennzeichnet, dass** jedes Paar von Eingangsleitungen (14, 15) die an den Anschlüssen (2) für mindestens zwei Gleichstromgeneratoren eingespeisten Ströme führt.

**Claims**

1. A method for monitoring an inverter (1) that comprises separate input-side connectors (2) for multiple direct-current generators with regard to the occurrence of a critical fault current ($I_R$),

   - wherein differential currents ($I_{diff}$) between input lines (14, 15) are measured in the inverter (1), wherein these input lines (14, 15) in their entirety conduct all currents that are fed in at the individual connectors (2), and
   - wherein the differential currents ($I_{diff}$) are compared with a limit value, wherein in the case of the limit value being exceeded this is recognized as a fault,

   **characterized in**

   - **that** the differential currents ($I_{diff}$) in the inverter (1) in at least two pairs of input lines (14, 15) are measured separately, wherein these at least two pairs of input lines (14, 15) conduct the currents that are fed in at different input-side connectors (2);
   - **that** the differential currents ($I_{diff}$) are compared with the limit value separately for each pair of input lines (14, 15); and
   - **that** additionally a sum of the simultaneously and separately measured differential currents ($I_{diff}$) in all pairs of input lines (14, 15) is determined and said sum is compared with a further limit value, wherein in the case of the further limit value being exceeded this is likewise recognized as a fault.

2. The method as claimed in claim 1, **characterized in that** the limit value with which the differential currents ($I_{diff}$) are compared separately for each pair of input lines (14, 15) is a limit value for a current increase within a specific period of time.

3. The method as claimed in claim 1 or 2, **characterized in that** the limit value with which the differential currents ($I_{diff}$) are compared separately for each pair of input lines (14, 15) is a limit value for an increase of a resistive fault current portion ($I_R$) of the differential currents ($I_{diff}$), wherein optionally the resistive fault current portion ($I_R$) of the measured differential currents ($I_{diff}$) is determined for each of the measured differential currents ($I_{diff}$) and that each of the measured differential currents ($I_{diff}$) is compared in the form of its resistive fault current portion ($I_R$) with the limit value.

4. The method as claimed in any one of the preceding claims, **characterized in that** the further limit value with which the sum of the simultaneously and separately measured differential currents ($I_{diff}$) in all pairs of input lines (14, 15) is compared is a limit value for a sum of the capacitive leakage current portions ($I_C$) of the differential currents ($I_{diff}$).

5. The method as claimed in claim 4, **characterized in that**

   - either the capacitive leakage current portion ($I_C$) of the measured differential currents ($I_{diff}$) is determined for each of the measured differential currents ($I_{diff}$) and that the sum of the simultaneously and separately measured differential currents ($I_{diff}$) in all pairs of the input lines (14, 15) is determined in the form of the sum of their capacitive leakage current portions ($I_C$) and said sum is compared with the further limit value,
   - or the sum of the simultaneously and separately measured differential currents ($I_{diff}$) in all pairs of the input lines (14, 15) is determined in the form of a capacitive leakage current portion of the sum of the simultaneously and separately measured differential currents ($I_{diff}$) and said sum is compared with the further limit value.

6. The method as claimed in any one of the preceding claims, **characterized in that** each pair of input lines (14, 15) conducts the currents that are fed in at the connectors (2) for at least two direct-current generators.

7. The method as claimed in any one of the preceding claims, **characterized in that** the inverter (1) is switched off in the case of a fault being recognized and/or is disconnected from an AC grid (11) that is connected on the output-side.

8. The method as claimed in any one of the preceding claims, **characterized in that** in the case of a fault being recognized at only one pair of input lines (14, 15), these input lines (14, 15) are selectively disconnected or the allocated connectors (2) are selectively switched off.

9. The method as claimed in any one of the preceding claims, **characterized in that** a drop in the differential current ($I_{diff}$) in a pair of input lines (14, 15) is evaluated as an indication of a failure of a direct-current generator that is connected thereto.

10. The method as claimed in any one of the preceding claims, **characterized in that** in addition the simultaneously and separately measured differential currents ($I_{diff}$) in the at least two pairs of input lines (14, 15) are compared with one another, wherein optionally additionally long term characteristics of the differential currents ($I_{diff}$) in the at least two pairs of input lines (14, 15) are evaluated.

11. An inverter (1) for performing the method as claimed in any one of the preceding claims having:

    - separate input-side connectors (2) for multiple direct-current generators,
    - measuring devices that measure the differential currents ($I_{diff}$) between input lines (14, 15) that conduct in their entirety all currents that are fed in at the connectors (2), and
    - monitoring devices that compare the differential currents ($I_{diff}$) with a limit value and in the case of the limit value being exceeded recognize this as a fault,

    **characterized in**

    - **that** the measuring devices comprise a separate differential current sensor (12) for each of at least two pairs of input lines (14, 15), wherein these at least two pairs of input lines (14, 15) conduct the currents that are fed in at different input-side connectors (2);
    - **that** the monitoring devices compare the differential currents ($I_{diff}$) that are measured by each of the differential current sensors (12) separately with the limit value; and
    - **that** the monitoring devices determine in addition a sum of the differential currents ($I_{diff}$) that are measured simultaneously and separately by means of all separate differential current sensors (12) and compare said sum with a further limit value and in the case of the further limit value being exceeded likewise recognize this as a fault.

12. The inverter as claimed in claim 11, **characterized in that** the monitoring devices determines a resistive fault current portion ($I_R$) of the measured differential currents ($I_{diff}$) for each of the differential currents ($I_{diff}$) that are measured by means of one of the differential current sensors (12), wherein the monitoring devices optionally compare each of the measured differential currents ($I_{diff}$) in the form of its resistive fault current portion ($I_R$) with the limit value.

13. The inverter as claimed in claim 11 or 12, **characterized in that** the monitoring devices determine a capacitive leakage current portion ($I_c$) of the measured differential currents ($I_{diff}$) for each of the differential currents ($I_{diff}$) that are measured by means of one of the differential current sensors (12), wherein the monitoring devices optionally determine the sum of the simultaneously and separately measured differential currents ($I_{diff}$) in all pairs of input lines (14, 15) in the form of the sum of their capacitive leakage current portions ($I_c$) and compare said sum with the further limit value.

14. The inverter as claimed in claim 11 or 12, **characterized in that** the monitoring devices determine the sum of the simultaneously occurring differential currents ($I_{diff}$) in all pairs of input lines (14, 15) in the form of a capacitive leakage current portion of the sum of the simultaneously and separately measured differential currents ($I_{diff}$) and compare said sum with the further limit value.

15. The inverter as claimed in any one of claims 11 to 14, **characterized in that** each pair of input lines (14, 15) conducts the currents that are fed in at the connectors (2) for at least two direct-current generators.

**Revendications**

1. Procédé de surveillance d'un onduleur (1) avec des bornes (2) séparées du côté de l'entrée pour plusieurs générateurs de courant continu en cas d'apparition d'un courant de défaut critique ($I_R$),

- dans lequel des courants différentiels ($I_{diff}$) entre les lignes d'entrée (14, 15) sont mesurés dans l'onduleur (1), lesdites lignes d'entrée (14, 15) transportant dans leur totalité tous les courants injectés aux bornes individuelles (2), et
- dans lequel les courants différentiels ($I_{diff}$) sont comparés à une valeur limite, un défaut étant détecté si la valeur limite est dépassée,

**caractérisé en ce que**

- les courants différentiels ($I_{diff}$) dans l'onduleur (1) sont mesurés séparément par l'intermédiaire d'au moins deux paires de lignes d'entrée (14, 15), ces au moins deux paires de lignes d'entrée (14, 15) transportant les courants injectés sur différentes bornes côté entrée (2) ;
- les courants différentiels ($I_{diff}$) pour chaque paire de lignes d'entrée (14, 15) sont comparés séparément à la valeur limite ; et
- en outre, une somme des courants différentiels ($I_{diff}$) mesurés séparément et simultanément sur toutes les paires de lignes d'entrée (14, 15) est déterminée et comparée à une autre valeur limite, un défaut étant également détecté si l'autre valeur limite est dépassée.

2. Procédé selon la revendication 1, **caractérisé en ce que** la valeur limite à laquelle les courants différentiels ($I_{diff}$) pour chaque paire de lignes d'entrée (14, 15) sont comparés séparément est une valeur limite pour une augmentation de courant dans un certain temps.

3. Procédé selon la revendication 1 ou 2, **caractérisé en ce que** la valeur limite à laquelle les courants différentiels ($I_{diff}$) pour chaque paire de lignes d'entrée (14, 15) sont comparés séparément est une valeur limite pour une augmentation d'une composante de courant de défaut résistif ($I_R$) des courants différentiels ($I_{diff}$), dans lequel, facultativement, pour chacun des courants différentiels mesurés ($I_{diff}$), sa composante de courant de défaut résistif ($I_R$) est déterminée et chacun des courants différentiels mesurés ($I_{diff}$) est comparé sous la forme de sa composante de courant de défaut résistif ($I_R$) à la valeur limite.

4. Procédé selon l'une quelconque des revendications précédentes, **caractérisé en ce que** l'autre valeur limite à laquelle est comparée la somme des courants différentiels ($I_{diff}$) mesurés simultanément et séparément sur toutes les paires de lignes d'entrée (14, 15) est une valeur limite pour une somme des composantes de courant de fuite capacitif ($I_C$) des courants différentiels ($I_{diff}$).

5. Procédé selon la revendication 4, **caractérisé en ce que**

- soit la composante de courant de fuite capacitif ($I_C$) de chacun des courants différentiels mesurés ($I_{diff}$) est déterminée, et **en ce que** la somme des courants différentiels ($I_{diff}$) mesurés séparément et simultanément sur toutes les paires de lignes d'entrée (14, 15) est déterminée sous la forme de la somme de leurs composantes de courant de fuite capacitif ($I_C$) et est comparée à l'autre valeur limite,
- soit la somme des courants différentiels ($I_{diff}$) mesurés simultanément et séparément sur toutes les paires de lignes d'entrée (14, 15) est déterminée sous la forme d'une composante de courant de fuite capacitif de la somme des courants différentiels ($I_{diff}$) mesurés simultanément et séparément et est comparée à l'autre valeur limite.

6. Procédé selon l'une quelconque des revendications précédentes, **caractérisé en ce que** chaque paire de lignes d'entrée (14, 15) véhicule les courants injectés aux bornes (2) pour au moins deux générateurs de courant continu.

7. Procédé selon l'une quelconque des revendications précédentes, **caractérisé en ce que** l'onduleur (1) est mis hors tension et/ou déconnecté d'un réseau alternatif (11) connecté du côté de la sortie lorsqu'un défaut est détecté.

8. Procédé selon l'une quelconque des revendications précédentes, **caractérisé en ce que** lorsqu'un défaut est détecté sur une seule paire de lignes d'entrée (14, 15), on déconnecte sélectivement lesdites lignes d'entrée (14, 15) ou on déconnecte sélectivement les bornes associées (2).

9. Procédé selon l'une quelconque des revendications précédentes, **caractérisé en ce qu'**une chute du courant différentiel ($I_{diff}$) à travers une paire de lignes d'entrée (14, 15) est évaluée comme une indication d'une défaillance d'un générateur de courant continu qui y est connecté.

10. Procédé selon l'une quelconque des revendications précédentes, **caractérisé en ce que,** en outre, les courants différentiels ($I_{diff}$) mesurés séparément et simultanément sur les au moins deux paires de lignes d'entrée (14, 15) sont comparés les uns aux autres, dans lequel, éventuellement, des évolutions à long terme des courants différentiels ($I_{diff}$) sur les au moins deux paires de lignes d'entrée (14, 15) sont évaluées.

11. Onduleur (1) pour la mise en oeuvre du procédé selon l'une des revendications précédentes avec :

- des bornes séparées côté entrée (2) pour plusieurs générateurs de courant continu,
- des moyens de mesure des courants différentiels ($I_{diff}$) entre les lignes d'entrée (14, 15) transportant dans leur totalité les courants injectés aux bornes (2), et
- des dispositifs de surveillance qui comparent les courants différentiels ($I_{diff}$) avec une valeur limite et détectent un défaut si la valeur limite est dépassée,

**caractérisé en ce que**

- les dispositifs de mesure présentent un capteur de courant différentiel (12) séparé pour chacune d'au moins deux paires de lignes d'entrée (14, 15), ces au moins deux paires de lignes d'entrée (14, 15) transportant les courants injectés sur différentes bornes côté entrée (2) ;
- les dispositifs de surveillance comparent séparément les courants différentiels ($I_{diff}$) mesurés avec chacun des capteurs de courant différentiel (12) avec la valeur limite ; et
- les dispositifs de surveillance déterminent en outre une somme des courants différentiels ($I_{diff}$) mesurés séparément en même temps avec tous les capteurs de courant différentiel séparés (12) et la comparent à une autre valeur limite et détectent également un défaut si l'autre valeur limite est dépassée.

**12.** Onduleur selon la revendication 11, **caractérisé en ce que** les moyens de surveillance déterminent pour chacun des courants différentiels ($I_{diff}$) mesurés avec l'un des capteurs de courant différentiel (12) sa composante de courant de défaut résistif ($I_R$), dans lequel les moyens de surveillance comparent facultativement chacun des courants différentiels mesurés ($I_{diff}$) sous la forme de sa composante de courant de défaut résistif ($I_R$) avec la valeur limite.

**13.** Onduleur selon la revendication 11 ou 12, **caractérisé en ce que** les moyens de surveillance déterminent pour chacun des courants différentiels ($I_{diff}$) mesurés avec l'un des capteurs de courant différentiel (12) sa composante de courant de fuite capacitif ($I_C$), dans lequel les moyens de surveillance déterminent facultativement la somme des courants différentiels ($I_{diff}$) mesurés simultanément séparément sur toutes les paires de lignes d'entrée (14, 15) sous la forme de la somme de leurs composantes de courant de fuite capacitif ($I_C$) et la comparent à la valeur limite supplémentaire.

**14.** Onduleur selon la revendication 11 ou 12, **caractérisé en ce que** les moyens de surveillance déterminent la somme des courants différentiels ($I_{diff}$) apparaissant simultanément sur toutes les paires de lignes d'entrée (14, 15) sous la forme d'une composante de courant de fuite capacitif de la somme des courants différentiels ($I_{diff}$) mesurés simultanément et séparément et la comparent à l'autre valeur limite.

**15.** Onduleur selon l'une quelconque des revendications 11 à 14, **caractérisé en ce que** chaque paire de lignes d'entrée (14, 15) véhicule les courants injectés aux bornes (2) pour au moins deux générateurs de courant continu.

**Fig. 1**

**Fig. 2**

$$I_{diff}\, 1 = I_{11} + I_{12}$$

$$I_{diff}\, 2 = I_{21} + I_{22}$$

**Fig. 3**

**Fig. 4**

EP 2 880 454 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20110210610 A1
- US 20120048326 A1
- US 20120049627 A1
- US 20020105765 A1

- WO 2011026874 A2
- EP 2372857 A1
- DE 102011002084 A1